# EUROPÄISCHE PATENTSCHRIFT

(11) **EP 0 695 117 B1**
(45) Veröffentlichungstag und Bekanntmachung des Hinweises auf die Patenterteilung: **26.03.1997**
(21) Anmeldenummer: 95111101.2
(22) Anmeldetag: 14.07.1995
(51) Int. Cl.: H05K 5/00

(54) **Steuergerät für ein Kraftfahrzeug**
Control device for motor vehicle
Dispositif de commande pour automobile

(30) Priorität: 26.07.1994 DE 4426465
(43) Veröffentlichungstag der Anmeldung: 31.01.1996
(73) Patentinhaber: SIEMENS AKTIENGESELLSCHAFT, 80333 München (DE)
(72) Erfinder: Zlamal, Vlastimil, D-93055 Regensburg (DE)

(56) Entgegenhaltungen:
- EP-A- 0 125 619
- EP-A- 0 488 193
- DE-U- 8 715 073
- US-A- 3 564 343

## Beschreibung

Die Erfindung betrifft ein Steuergerät für ein Kraftfahrzeug, bei dem elektrische Anschlüsse im Inneren eines Gehäuses, an die beispielsweise in der Technik des Bondens elektronische Baugruppen angeschlossen werden, mit elektrischen Anschlüssen, die aus dem Gehäuse zum Beispiel in Form von Steckerstiften herausragen, miteinander verbunden werden, um das Steuergerät mit anderen Steuergeräten oder Leitungssteckern zu verbinden.

Bisher hat man zur Verbindung solcher Anschlüsse gestanzte Metallstreifen verwendet (DE 36 11 224 A1 oder DE 87 15 073), die mit isolierendem Kunststoff umspritzt und fixiert wurden. Nach außen hin waren dann nur die inneren und äußeren Anschlüsse sichtbar. Solche gestanzten Metallstreifen eignen sich aber nur für Verbindungen, bei denen sowohl die inneren als auch die äußeren Anschlüsse selbst relativ groß in der Ausdehnung sind und bei denen bei mehrfachen Anschlüssen, zum Beispiel bei einem Mehrfachstecker, die einzelnen Anschlüsse relativ weit voneinander entfernt sind. Sind die Anschlüsse selbst aber klein und sind sie dicht beieinander angeordnet, so eignen sich als Verbindungen die gestanzten Metallstreifen nicht mehr. Die nun erforderlichen Strukturen sind zu fein zum Stanzen. Es besteht außerdem die Gefahr, daß sich die feinen und dicht beieinander liegenden Leiterstrukturen beim Umgießen mit Kunststoff verbiegen, so daß es zu Kurzschlüssen kommen kann.

Die Aufgabe der vorliegenden Erfindung ist es daher, ein Steuergerät für ein Kraftfahrzeug zu schaffen mit einer Verbindungsstruktur zwischen äußeren und inneren elektrischen Anschlüssen, die auch bei sehr kleinen und dicht beieinander liegenden Anschlüssen noch verwendbar ist. Gemäß dem Anspruch 1 wird diese Aufgabe dadurch gelöst, daß die Verbindungsstruktur durch Leiterbahnen auf einer Leiterplatte hergestellt wird. Durch diese "Verbindungsleiterplatte" werden die äußeren und inneren Anschlüsse durch eine Leiterstruktur verbunden, die sehr schmale und sehr dicht beieinander liegenden Leiterbahnen erlaubt, die sich außerdem beim Umspritzen mit Kunststoff nicht deformieren, sondern unverrückbar an ihren Orten bleiben.

Die Erfindung wird nachfolgend anhand der Zeichnungsfiguren näher beschrieben.

Es zeigen:
- Fig. 1: ein Steuergerät nach dem Stand der Technik,
- Fig. 2: Ansicht eines erfindungsgemäßen Steuergeräts,
- Fig. 3: einen Schnitt durch das erfindungsgemäße Steuergerät entlang der Linie III-III in Fig. 2,
- Fig. 4: eine Draufsicht auf ein erfindungsgemäßes Steuergerät und
- Fig. 5: einen Schnitt durch das Steuergerät entlang der Linie V-V in Fig. 4.

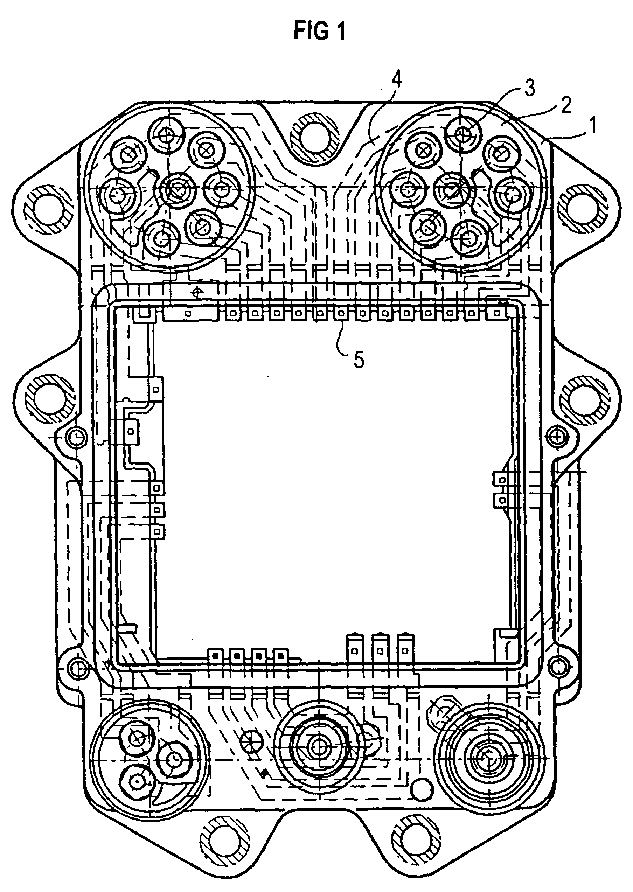

Figur 1 zeigt ein Gehäuse 1 eines Steuergeräts nach dem Stand der Technik. Es hat an seiner Außenseite verschiedene Mehrfachstecker 2. Diese besitzen einzelne Steckerstifte 3 über die das Gehäuse mit anderen Gehäusen oder Leitungssteckern verbunden werden kann. Von den Steckerstiften 3 führen gestanzte Leiterbahnen 4 zu Anschlüssen 5 im Inneren des Gehäuses. In diesem Ausführungsbeispiel bestehen die Anschlüsse 5 aus Bondpads, an die dann mittels gebondeter Drähte, die sich im Inneren des Gehäuses befindlichen elektronischen Baugruppen angeschlossen werden. Die gestanzten Leiterbahnen 4 sind zur Halterung und Isolierung mit dem Kunststoff umgossen, aus dem das gesamte Gehäuse gegossen ist. Sie sind deswegen auch gestrichelt dargestellt, da sie nach außen hin nicht sichtbar sind.

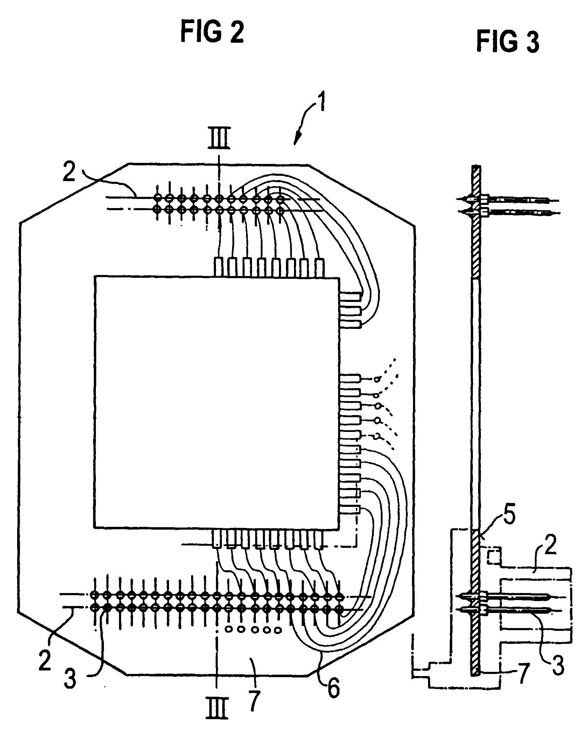

In Figur 2 ist ein erfindungsgemäßes Steuergerät, z.B. ein Zünd- oder Motorsteuergerät eines Kraftfahrzeugs, mit einer Verbindungsstruktur dargestellt, die die bisher verwendeten gestanzten Leiterbahnen ersetzt. Schematisch sind zwei Mehrfachstecker 2 mit Steckerstiften 3 dargestellt. Die Anschlüsse im Inneren des Gehäuses 1 sind mit dem Bezugszeichen 5 bezeichnet. Die Verbindung zwischen den Steckerstiften 3 und den Anschlüssen 5 im Inneren des Gehäuses erfolgt nun durch Leiterbahnen 6, die auf einer Verbindungsleiterplatte 7 angebracht sind.

In Figur 3 sieht man den Querschnitt durch die Struktur nach Figur 2 entlang der Linie III-III. Auf der Verbindungsleiterplatte 7 sind die Steckerstifte 3 der Mehrfachstecker 2 elektrisch kontaktiert, zum Beispiel angelötet oder eingepreßt. Die Anschlüsse 5 im Innern des Gehäuses sind hier als Bondpads ausgeführt, die aus einem breiteren Endbereich der entsprechenden Leiterbahn, die die einzelnen Steckerstifte mit dem zugehörigen Anschluß im Innern des Gehäuses verbindet, bestehen und die gegebenenfalls mit einem bondbaren Material, wie Gold, Aluminium oder Nickel beschichtet sind.

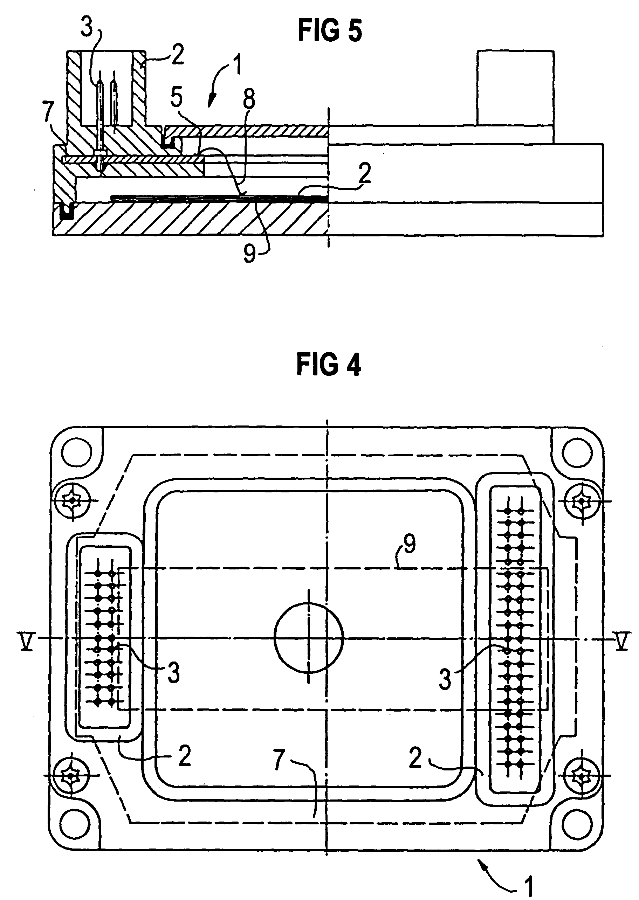

In Figur 4 ist die Draufsicht auf ein Steuergerät mit einem Gehäuse 1 mit zwei Mehrfachsteckern 2, die einzelne Steckerstifte 3 aufweisen, dargestellt. Die Schaltung ist der Übersichtlichkeit halber nicht gezeichnet. Die Verbindungsleiterplatte 7 ist als gestrichelte Struktur dargestellt, da sie mit Kunststoff umspritzt oder in das Kunststoffteil eingedrückt oder anderweitig eingebettet fest im Steckergehäuse 1 integriert wurde und nach außen nicht sichtbar ist.

Figur 5 zeigt einen halbseitigen Querschnitt durch das in Figur 4 dargestellte Gehäuse entlang der Linie V-V. Es ist lediglich eine einziger Mehrfachstecker 2 mit den einzelnen Steckerstiften 3 dargestellt. Die Steckerstifte 3 sind auf der Verbindungsleiterplatte 7 elektrisch kontaktiert, zum Beispiel angelötet oder eingepreßt und über hier nicht sichtbare Leiterbahnen auf der Verbindungsleiterplatte mit den Anschlüssen 5 im Innern des Gehäuses verbunden. Von den Anschlüssen 5 führen weitere Bonddrähte 8 zu einer Substratleiterplatte 9, die die elektronischen Baugruppen einer im Gehäuse befindlichen elektrischen Schaltung trägt.

## Patentansprüche

1. Steuergerät für ein Kraftfahrzeug mit
- einem Gehäuse (1)
- zumindest einem Steckerteil (2) mit äußeren, elektrischen Anschlüssen (3),
- einer Hauptleiterplatte (9), auf der eine Schaltung angeordnet ist, und
- elektrischen Verbindungen (8) zwischen inneren Anschlüssen (5) und der Hauptleiterplatte (9),
**gekennzeichnet durch**
eine Zusatzleiterplatte (7), auf der das Steckerteil befestigt ist und die die äußeren Anschlüsse (3) sowie die inneren Anschlüsse (5) über Leiterbahnen (6) elektrisch miteinander verbindet, wobei die Zusatzleiterplatte (7) in Kunststoff eingebettet ein Teil des Gehäuses (1) bildet.

2. Steuergerät nach Anspruch 1,
**dadurch gekennzeichnet,**
daß die äußeren Anschlüsse als Steckerstifte (3) eines Mehrfachsteckers (2) ausgebildet sind

3. Steuergerät nach Anspruch 2,
**dadurch gekennzeichnet,**
daß die Steckerstifte (3) auf der Leiterplatte (7) angelötet oder eingepreßt sind.

4. Steuergerät nach Anspruch 1,
**dadurch gekennzeichnet,**
daß die inneren Anschlüsse (5) als Bondpads ausgebildet sind.

5. Steuergerät nach Anspruch 4,
**dadurch gekennzeichnet,**
daß die Bondpads als verbreiterte Enden der Leiterbahnen (6) ausgebildet sind und mit einem bondbaren Material wie Gold, Aluminium oder Nickel beschichtet sind.

## Claims

1. Control device for a motor vehicle having
- a housing (1)
- at least one plug component (2) with outer, electrical terminals (3),
- a main circuit board (9) on which a circuit is arranged, and
- electrical connections (8) between internal terminals (5) and the main circuit board (9),
characterized by
an additional circuit board (7) to which the plug component is attached and which connects the external terminals (3) and the internal terminals (5) electrically to one another via conductor tracks (6), the additional circuit board (7) being embedded in plastic, forming part of the housing (1).

2. Control device according to Claim 1, characterized in that the external terminals are constructed as plug pins (3) of a multiple plug (2).

3. Control device according to Claim 2, characterized in that the plug pins (3) are soldered onto or pressed into the circuit board (7).

4. Control device according to Claim 1, characterized in that the internal terminals (5) are constructed as bond pads.

5. Control device according to Claim 4, characterized in that the bond pads are constructed as widened ends of the conductor tracks (6) and are coated with a bondable material such as gold, aluminium or nickel.

## Revendications

1. Dispositif de commande, pour véhicule automobile, comprenant :
- un boîtier (1),
- au moins une partie formant connecteur (2) comportant des bornes électriques extérieures (3),
- une plaquette de circuit imprimé principale (9), sur laquelle un circuit est disposé, et
- des liaisons électriques (8) entre des bornes intérieures (5) et la plaquette de circuit imprimé principale (9),
caractérisé par :
- une plaquette de circuit imprimé supplémentaire (7) sur laquelle la partie formant connecteur est fixée et qui relie électriquement entre elles les bornes extérieures (3) et les bornes intérieures (5) par l'intermédiaire de pistes conductrices (6), la plaquette de circuit imprimé supplémentaire (7) constituant une partie du boîtier (1) en étant noyée dans la matière plastique.

2. Dispositif de commande selon la revendication 1, caractérisé en ce que les bornes extérieures sont réalisées sous forme de broches de connecteur (3) d'un connecteur multiple (2).

3. Dispositif de commande selon la revendication 2, caractérisé en ce que les broches de connecteur (3) sont soudées ou emboîtées à force sur la plaquette de circuit imprimé (7).

4. Dispositif de commande selon la revendication 1, caractérisé en ce que les bornes intérieures (5) sont réalisées sous forme de plots de soudage.

5. Dispositif de commande selon la revendication 4, caractérisé en ce que les plots de soudage sont réalisés sous forme d'extrémités plus larges que les pistes conductrices (6) et sont revêtus d'une matière soudable, telle qu'or, aluminium ou nickel.
